Europäisches Patentamt

European Patent Office

Office européen des brevets

(11) Veröffentlichungsnummer: **0 002 451**
**A1**

# (12) EUROPÄISCHE PATENTANMELDUNG

(21) Anmeldenummer: **78101406.3**

(22) Anmeldetag: **18.11.78**

(51) Int. Cl.²: **G 01 R 31/26**
**G 01 N 27/02, G 01 N 27/86**
**H 01 L 23/00**

(30) Priorität: **12.12.77 US 859352**

(43) Veröffentlichungstag der Anmeldung:
**27.06.79 Patentblatt 79/13**

(84) Benannte Vertragsstaaten:
**DE FR GB**

(71) Anmelder: **International Business Machines**
**Corporation**

**Armonk, N.Y. 10504(US)**

(72) Erfinder: **Pak, Mun Sok**
**Gold Road**
**Stormville New York 12582(US)**

(72) Erfinder: **Verkuil, Roger Leonard**
**197 Vassar Road**
**Poughkeepsie, New York 12603(US)**

(74) Vertreter: **Lewit, Leonard, Dipl.-Ing.**
**Schönaicher Strasse 220**
**D-7030 Böblingen(DE)**

(54) **Verfahren und Anordnung zur berührungsfreien Messung von Verunreinigungsstellen in Halbleitern.**

(57) Zur berührungsfreien Messung von Verunreinigungsstellen im Kristallgefüge eines Siliciumscheibchens (1), die durch Sauerstoffatome im Halbleitermaterial hervorgerufen werden, wird das Siliciumscheibchen mit pulsierendem Licht bestrahlt und zugleich einem Hochfrequenzfeld ausgesetzt. Durch die im Halbleiterscheibchen hervorgerufenen Wirbelströme ändert sich die Belastung des Hochfrequenzoszillators (6). Aus dem Amplitudenverlauf der Hochfrequenzschwingungen wird auf die Anzahl der Fehlerstellen im Kristallgefüge geschlossen. Zur Unterdrückung der langsamen Aenderung der Amplitudeneinhüllenden am Ende des Lichtimpulses wird das Siliciumscheibchen (1) ausserdem mit kontinuierlichem Licht bestrahlt.

FIG. 1

siehe Titelseite

Verfahren zur berührungsfreien Messung von Verunreinigungsstellen in Halbleitern

Die Erfindung betrifft ein Meßverfahren der im Oberbegriff
des Anspruchs 1 beschriebenen Art sowie eine Anordnung zur
Durchführung dieses Verfahrens.

Verfahren zum berührungsfreien Messen der Photoleitfähigkeits-
Abfallzeit in Halbleitermaterialien sind bekannt. So ist
beispielsweise in dem Aufsatz mit dem Titel "Contactless
Measurement of Resistivity of Slices of Semiconductor Materials" von Nobuo Miyamoto u.a. in Review of Scientific
Instruments, Band 38, Nr. 3, vom März 1967 auf Seite 360ff,
ein hochfrequentes, mit kapazitiver Kopplung arbeitendes
Verfahren beschrieben, während in dem Aufsatz mit dem Titel
"Simple Contactless Method for Measuring Decay Time of
Photoconductivity in Silicion" von R. M. Lichtenstein u.a. in
Review of Scientific Instruments, Band 38, Nr. 1 vom Januar
1967, Seite 133ff, ein Verfahren mit induktiver Einkopplung
von Hochfrequenz beschrieben ist. Bei beiden Verfahren
wird die Schwingungsamplitude eines hochfrequenten Trägers
überwacht, der entweder kapazitiv oder induktiv mit der
Halbleiterprobe gekoppelt ist, während die Probe mit pulsierendem Licht bestrahlt wird. Jeder Lichtimpuls erregt
elektrische Ladungsträger, d.h., es werden freie Elektronen
erzeugt, welche Fangstellen im Kristallgefüge sättigen. Damit wird kurzzeitig die Belastung des Hochfrequenzoszilla-

FI 977 047

tors erhöht, was eine entsprechende Abnahme der Amplitude der Schwingungen zur Folge hat. Am Ende des Lichtimpulses nimmt die Amplitude der Schwingungen wieder ihren Wert des eingeschwungenen Zustands mit einer Geschwindigkeit ein, die durch die Rekombinationsgeschwindigkeit der Ladungsträger in der bestrahlten Probe bestimmt wird.

Zur Messung des Leckstromes über einen PN-Übergang ist eine Meßmethode bekannt geworden, nach der ebenfalls die Abfallzeit eines elektrischen Signales bestimmt wird (DE-OS 2 655 938).

Es hat sich jedoch herausgestellt, daß diese bekannten Methoden sich nicht eignen zur Messung des z. B. von Sauerstoffatomen in Zwischengitterplätzen hervorgerufenen Verunreinigungsgrades in Siliciumscheiben. Wohl kann hierzu die sogenannte ASTM-IR-Methode (American Society for Testing and Materials Infrarotmethode) verwendet werden, welche auf spektrophotometrischen Messungen beruht. Die Auswertung der Meßergebnisse nach dieser Methode ist jedoch sehr zeitaufwendig.

Der vorliegenden Erfindung liegt daher die Aufgabe zugrunde, die rasche und berührungsfreie Messung von Verunreinigungen in einem übergangsfreien Halbleitermaterial zu ermöglichen.

Das erfindungsgemäße Verfahren zur Lösung dieser Aufgabe ist im Anspruch 1 gekennzeichnet.

Ein Vorteil dieses Verfahrens resultiert aus dem linearen Zusammenhang zwischen der erfindungsgemäßen Amplitudenmessung und der Anzahl der durch Sauerstoffatome besetzten Fangstellen im Kristallgefüge. Außerdem nimmt die erfindungsgemäße Messung nur ca. 30 Sekunden in Anspruch, während die bekannte ASTM-IR-Methode ca. 30 Minuten dauert.

FI 977 047

- 3 -

Die erfindungsgemäße Anordnung zur Durchführung des Verfahrens gestattet bei einfachem Aufbau die Realisierung der beschriebenen Vorteile.

Vorteilhafte Weiterbildungen der Erfindung sind den Unteransprüchen zu entnehmen.

Die Erfindung soll nun anhand eines in den Figuren gezeigten Ausführungsbeispieles näher beschrieben werden. Es zeigen:

Fig. 1    die schematische Darstellung einer bevorzugten Ausführungsform der Erfindung,

Fig. 2    den auf dem in Fig. 1 gezeigten Bildschirm sichtbaren Amplitudenverlauf des Meßimpulses,

Fig. 3    in einem Diagramm einen Vergleich der Meßergebnisse nach der vorliegenden Erfindung mit den nach der bekannten ASTM-IR-Methode erhaltenen Ergebnissen für einen zentralen Bereich der zu untersuchenden Halbleiterscheibe und

Fig. 4    ein dem in Fig. 3 gezeigten Diagramm ähnliches Diagramm, wobei jedoch mehrere verschiedene Gebiete der Halbleiterscheibe für die Messung verwendet wurden.

Die Ausbeute bei der Produktion von hochintegrierten Halbleiterschaltungen wird durch kristallographische Defekte empfindlich herabgesetzt. Mit dem nachfolgend beschriebenen Ausführungsbeispiel der Erfindung ist es möglich, solche störende Defekte schon frühzeitig in der Produktion und speziell sogar schon vor der Bildung von Halbleiterübergängen festzustellen. Es ist festgestellt worden, daß ein konkreter Zusammenhang besteht

FI 977 047

zwischen den durch die Anwesenheit von Sauerstoffatomen im Kristallgefüge hervorgerufenen Fehlern und einer Verringerung der Herstellungs-Ausbeute. Die nachfolgend beschriebene Einrichtung gestattet insbesondere eine rasche, präzise, berührungsfreie und zerstörungsfreie Messung solcher Sauerstoffehlstellen im Kristallgefüge.

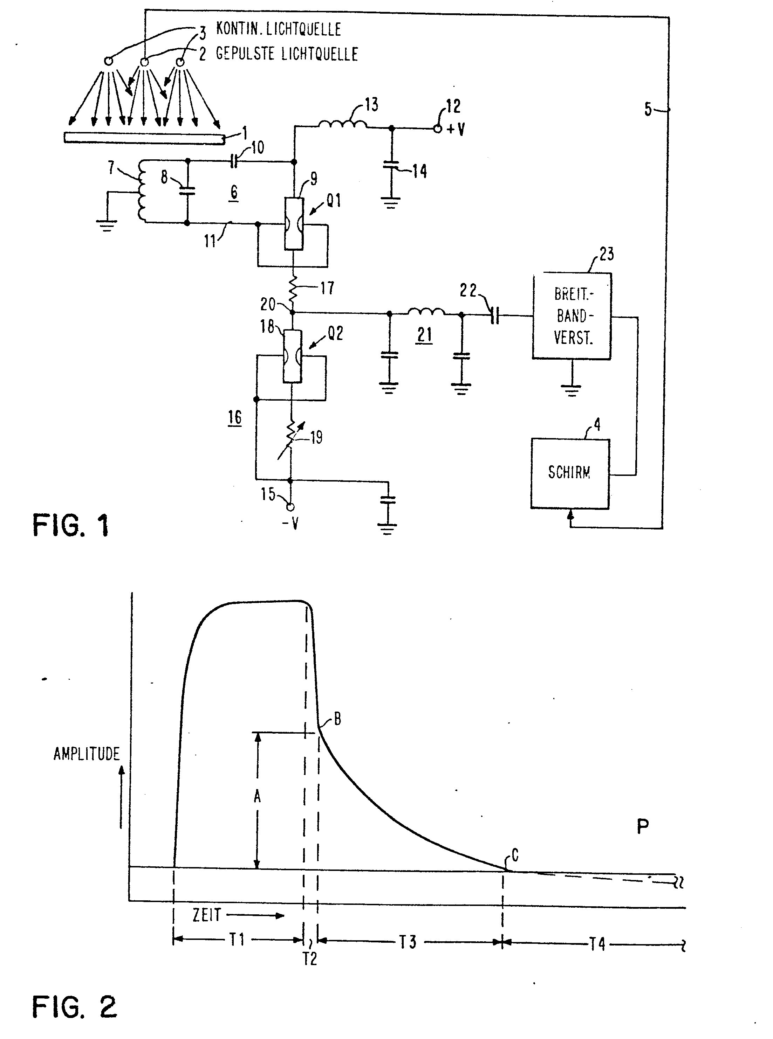

In Fig. 1 ist ein Halbleiterscheibchen 1 gezeigt, das als Grundlage zur Herstellung von hochintegrierten Schaltungen dienen soll. Zur Durchführung des erfindungsgemäßen Meßverfahrens wird die Scheibe 1 von einer pulsierenden Lichtquelle 2 bestrahlt, wodurch im Halbleitermaterial genügend freie Elektronen zur Sättigung der Fangstellen im Halbleitermaterial erzeugt werden. Beispielsweise kann pulsierendes infrarotes Licht mit einer Wellenlänge von ca. 1 µm verwendet werden.

Die Halbleiterscheibe 1 wird ferner von einer Quelle 3 kontinuierlichen Lichts bestrahlt. Die Intensität dieses kontinuierlichen Lichtstromes wird auf eine passende Intensität eingestellt. Ein Hochfrequenzoszillator 6 mit einer Frequenz zwischen 50 und 200 MHz ist mit der Halbleiterscheibe 1 über eine Tankkreisspule 7 induktiv gekoppelt. Die Spule 7 bildet zusammen mit dem Kondensator 8 einen Resonanzkreis. Der Mittelpunkt der Wicklung der Spule 7 ist mit Erde verbunden, wodurch die Aufnahme von Störsignalen durch die Spule kleingehalten wird. Der Oszillator 6 weist ferner einen Sperrlagenfeldeffekttransistor 9 auf, der an den Resonanzkreis über einen Kondensator 10 und eine Leitung 11 angekoppelt ist. Der Feldeffekttransistor 9 ist an eine positive Speisespannung 12 über eine geeignete Hochfrequenzdrossel 13 und einen Siebkondensator 14 angeschlossen. Der Transistor ist außerdem vorzugsweise mit einer negativen Speisespannung 15 über einen Widerstand 17 und eine Konstantstromquelle 16 verbunden, welche einen Feldeffekttransistor 18 und einen regelbaren Widerstand 19 aufweist. Mit dem Widerstand 19 kann der Oszillator 6 auf hohe Empfindlichkeit gegenüber Belastungen des Oszillatorschwingkreises durch die Halbleiterscheibe 1 eingeregelt werden. Mit der Konstantstromquelle 16 kann die Amplitude der Schwingungen so eingeregelt werden, daß sie gerade unterhalb eines Wertes liegt, an dem eine nicht lineare Begrenzung einsetzen würde. Hierdurch wird ein sehr gutes Nutz/Störverhältnis des Signales erzielt, das am Schirm des Oszillographen 4 angezeigt werden soll. Außerdem wird hierdurch die Empfindlichkeit der Meßanordnung gegenüber den festzustellenden Sauerstoffeinschlüssen erhöht.

Die Amplitude der vom Oszillator 6 erzeugten Hochfrequenzschwingungen wird durch jeden Lichtimpuls von der Quelle 2 moduliert. Die demodulierte Hochfrequenzschwingung ist am Punkt 20 erhältlich und wird über ein auf die Trägerfrequenz abgestimmtes Sperrfilter 21 und einen Kondensator einem Breitbandverstärker 23 zugeführt. Das Ausgangssignal dieses Verstärkers wird den Vertikaleingängen des Oszillographen 4 zugeführt. Die Triggerung der Horizontalablenkung erfolgt über Impulse auf der Leitung 5, welche synchron zu den Lichtimpulsen der Quelle 2 sind.

Das Feld der Spule 7 erzeugt im Halbleiterscheibchen Wirbelströme. Dabei besteht ein umgekehrt proportionaler Zusammenhang zwischen der Amplitude der Hochfrequenzschwingungen und der Amplitude der Wirbelströme im Halbleiter 1. Die Amplitude der Wirbelströme hängt jedoch ihrerseits von der Arbeit ab, welche das durch die Wirbelströme erzeugte elektrische Feld bei der Bewegung von elektrischen Ladungen durch die Scheibe 1 leisten muß. Solche Ladungen werden in der Scheibe 1 immer erzeugt, wenn ein Lichtimpuls auf die Scheibe trifft. Nach jedem Lichtimpuls findet eine

FI 977 047

Rekombination der Ladungen statt, wobei die Geschwindigkeit der Rekombination aus Fig. 2 ersichtlich ist.

Fig. 2 zeigt den zeitlichen Verlauf des auf dem Schirm des Oszillographen 4 sichtbaren Signales. Das in Fig. 2 gezeigte Diagramm entspricht der invertierten Einhüllenden des pulsmodulierten Signales im Punkt 20 der Schaltung. Während der in Fig. 2 gezeigten Zeit $T_1$ trifft ein Lichtimpuls von der Quelle 2 auf die Scheibe 1. Während dieser Zeit wird ein dynamischer Gleichgewichtszustand zwischen Erzeugung und Rekombination erreicht hinsichtlich der freien Ladungsträgerpopulation und eine Auffüllung der durch die Sauerstoffatome hervorgerufenen Fangstellen in der Scheibe 1. Sofort nach Beendigung des Lichtimpulses findet eine rasche Rekombination der freien Ladungsträger statt, die in der Zeitperiode $T_1$ erzeugt wurden und keine Fangstellen auffüllten. Diese rasche Rekombination findet in der Zeit $T_2$ statt, die ungefähr 10 µs beträgt.

Während einer Zeit $T_3$, welche typischerweise 10 ms beträgt, werden die freien Elektronen, die in der Zeit $T_1$ in die Fangstellen gehoben wurden, thermisch wieder losgelassen. Die in Fig. 2 gezeigte Amplitude A der Einhüllenden, die also unmittelbar nach der schnellen Rekombination und unmittelbar vor dem langsamen Auswandern der freien Elektronen aus den Fangstellen festgestellt werden kann, steht zur Anzahl der durch Sauerstoffatome hervorgerufenen Fangstellen in unmittelbarer Beziehung. Das vorliegende Meßverfahren konzentriert sich also auf die Feststellung dieser Amplitude. Ergänzend soll noch hinzugefügt werden, daß der Teil P des Amplitudenverlaufes in der Zeit $T_4$, welche ungefähr eine Sekunde lang ist, für die Messung ohne Bedeutung ist. Dieser Teil kann durch das kontinuierliche Licht von der Quelle 3 unterdrückt werden. Dabei wird so vorgegangen, daß

FI 977 047

- 7 -

die Intensität des kontinuierlichen Lichtes erhöht wird
und zugleich darauf geachtet wird, daß die Amplitude A gleich
bleibt. der maximale Wert einer solchermaßen eingestellten
Intensität wird dann bei der Messung beibehalten. Der Teil
P der Kurve ergibt sich aus der langsamen Abnahme von außerordentlich stabilen Energiezuständen, die durch den Lichtimpuls hervorgerufen wurden.

Die Amplitude A wird festgestellt durch die Messung der
vertikalen Distanz zwischen den in Fig. 2 gezeigten Kurvenpunkten B und C. Dabei wird so vorgegangen, daß zunächst für
eine Halbleiterscheibe mit einer noch zulässigen Anzahl von
Fehlern im Kristallgefüge der Wert A gemessen wird. Bei den
darauffolgenden Messungen werden dann Halbleiterscheiben
als gut betrachtet, wenn ihr Wert A kleiner ist als der
Referenzwert A und im gegenteiligen Falle als schlecht betrachtet. Dabei muß natürlich darauf geachtet werden, daß
die Vergleichshalbleiterscheibe unter denselben Umständen
hergestellt wurde wie die zu messenden Scheiben, das gilt
insbesondere hinsichtlich der Oberflächenbehandlung und
der thermischen Behandlung. Mit der Oberflächenbehandlung
soll eine genügend hohe Oberflächen-Rekombinationsgeschwindigkeit erzeugt werden, um sicherzustellen, daß die
Zeit $T_2$ sehr klein ist gegen die Zeit $T_3$. Nur dann kann
ein deutlicher Knick in der Kurve beim Punkt B in Fig. 2
festgestellt werden. Die thermische Behandlung ist ihrerseits wieder verantwortlich für die Konzentration der
durch Sauerstoff hervorgerufenen Fangstellen (für eine
gegebene Zwischengitter-Sauerstoffkonzentration).

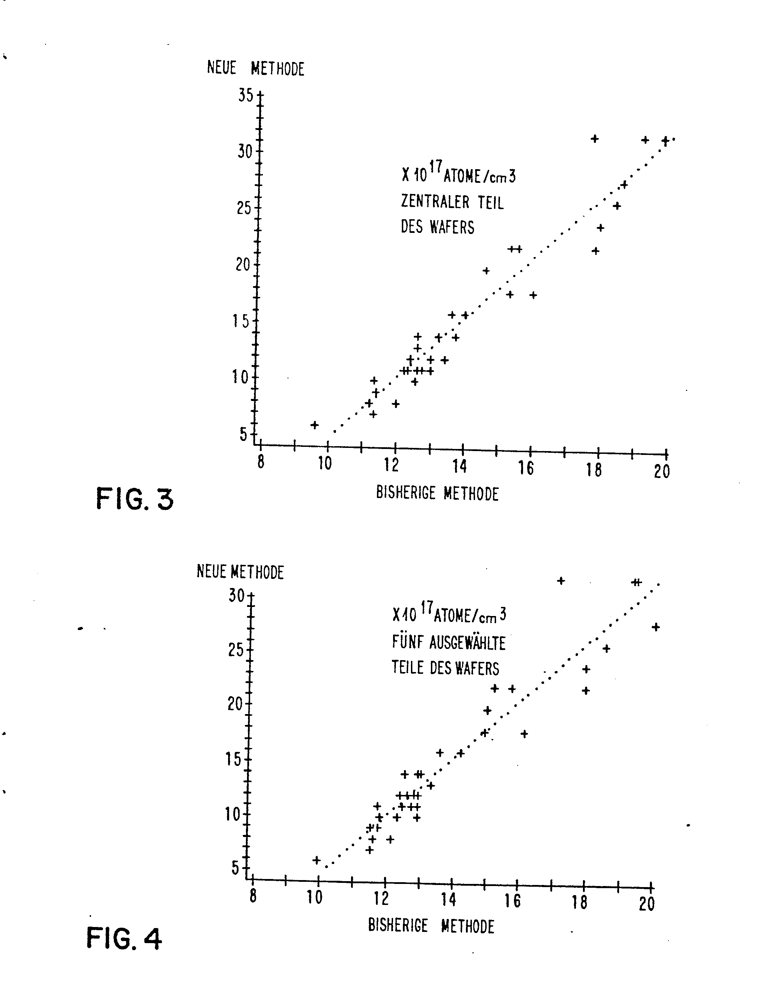

Fig. 3 zeigt für 37 Exemplare von 82,5 mm Siliciumscheiben
den Zusammenhang der nach der vorliegenden Erfindung erzielten Meßergebnisse mit Meßergebnissen der bekannten
ASTM-IR-Methode. Die mit "+" bezeichneten Punkte in Fig. 3
haben einen Ordinatenwert, der durch eine Messung nach dem

FI 977 047

- 8 -

erfindungsgemäßen Verfahren an einer bestimmten Halbleiterscheibe erhalten wurde und einen Abszissenwert, der durch Messung an der gleichen Halbleiterscheibe nach der bekannten Methode erhalten wurde. Alle in Fig. 3 gezeigten Messungen wurden im Zentralbereich der Scheibe durchgeführt.

Fig. 4 zeigt einen ähnlichen Zusammenhang, wobei jedoch nicht nur in der Mitte der Scheibe, sondern insgesamt an fünf Bereichen der Scheibe gemessen wurde. Die punktierten Linien in Fig. 3 und Fig. 4 zeigen die beste Annäherung an die Meßresultate.

Das erfindungsgemäße Meßverfahren gestattet also eine schnelle, präzise, berührungsfreie und nicht destruktive Messung von Sauerstoff-Zwischengitterstellen in Halbleiterscheiben. Es wurde festgestellt, daß die Meßempfindlichkeit von 9 bis zu ca. $20 \cdot 10^{17}$ Sauerstoffatomen/cm$^3$ reicht. Die Auflösung der Messung beträgt ca. $\pm 0{,}37 \cdot 10^{17}$ Sauerstoffatome/cm$^3$.

FI 977 047

- 1 -

<u>P A T E N T A N S P R Ü C H E</u>

1.  Verfahren zur berührungsfreien Messung des Verunreinigungsgrades in Halbleiterscheiben, gekennzeichnet durch die folgenden Schritte:
    - induktive Einkopplung von Hochfrequenzschwingungen in die sperrlagenfreie Halbleiterscheibe zur Erzeugung von Wirbelströmen in der Scheibe,
    - Bestrahlen der Halbleiterscheibe mit pulsierendem Licht zur Amplitudenmodulation der Hochfrequenzschwingung,
    - Demodulation der Hochfrequenzschwingung und
    - Untersuchung des erhaltenen, einhüllenden Amplitudenverlaufes (Fig. 2) auf rasche Änderung nach Beendigung des Lichtimpulses und daran anschließenden knickartigen Übergang (Punkt B), wobei die Amplitude (A) im Knickpunkt ein Maß für den Verunreinigungsgrad ist.

2.  Verfahren nach Anspruch 1, dadurch gekennzeichnet, daß die Untersuchung mit Hilfe eines Oszillographen erfolgt.

3.  Verfahren nach Anspruch 1, dadurch gekennzeichnet, daß der letzte, zeitlich sich sehr langsam ändernde Ast (P) des Amplitudenverlaufes durch eine Bestrahlung der Halbleiterscheibe mit kontinuierlichem Licht unterdrückt wird.

FI 977 047

4. Verfahren nach Anspruch 1, dadurch gekennzeichnet, daß die Messung an einer Silicumscheibe mit Verunreinigungs-Sauerstoffatomen in Zwischengitterplätzen erfolgt.

5. Verfahren nach den Ansprüchen 1 bis 3, dadurch gekennzeichnet, daß der inverse Verlauf der demodulierten Hochfrequenzschwingung dargestellt wird (Fig. 2).

6. Anordung zur Durchführung des Verfahrens nach einem oder mehreren der vorhergehenden Ansprüche, gekennzeichnet durch
   eine Lichtquelle (2) zur Erzeugung eines pulsierenden Lichtes,
   eine Lichtquelle (3) zur Erzeugung eines kontinuierlichen Lichtes,
   einen Hochfrequenzoszillator (6) mit einem Schwingkreis, dessen Induktivität (7) mit der Halbleiterscheibe (1) induktiv zur Erzeugung von Wirbelströmen in der Scheibe gekoppelt ist,
   einen Konstantstromkreis (16) zur Speisung des Oszillators mit einstellbarem konstantem Strom,
   einen Breitbandverstärker (23), der eingangsseitig über ein Hochfrequenzfilter (21) an einen zwischen der Konstantstromquelle und einem mit dem Oszillator verbundenen Widerstand (17) liegenden Punkt (20) verbunden ist und der ein Signal zur Anzeige an ein Sichtgerät (4) liefert.

7. Anordnung nach Anspruch 6, dadurch gekennzeichnet, daß der Oszillator (6) und die Konstantstromquelle (10) je einen Sperrlagenfeldeffekttransistor (Q1, Q2) aufweisen.

FI 977 047

FIG. 1

FIG. 2

FIG. 3

FIG. 4

Europäisches
Patentamt

**EUROPÄISCHER RECHERCHENBERICHT**

| **EINSCHLÄGIGE DOKUMENTE** | | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| DA | DE – A – 2 655 938 (IBM) <br> * Das ganze Dokument * <br><br> ———— | 1 | |
| | | | RECHERCHIERTE SACHGEBIETE (Int. Cl.²) |
| | | | |

EPA Form 1503.2   06.78

0002451

## EINSCHLÄGIGE DOKUMENTE

| Kategorie | Kennzeichnung des Dokuments mit Angabe. soweit erforderlich. der maßgeblichen Teile | betrifft Anspruch |
|---|---|---|
| | <u>DE – B – 1 067 934</u> (SIEMENS) <br> * Das ganze Dokument * | 1,2 |
| | <u>DE – A – 1 464 355</u> (PHILIPS) <br> * Seite 8, Patentanspruch 1; Abbildung 1 * | 1 |
| A | <u>US – A – 3 805 160</u> (J.W. PHILBRICK) <br> * Spalte 2, Zeilen 11-53; Abbildung 1 * | 1 |
| A | <u>US – A – 3 919 639</u> (K. GRAFF) <br> * Spalte 1, Zeile 57 bis Spalte 4, Zeile 29; Abbildungen 1-4 * | 1,2 |
| A | <u>US – A – 3 745 454</u> (R.G. NIKIRK) <br> * Spalte 1, Zeile 51 bis Spalte 2, Zeile 3; Abbildung 1 * | 1,2 |
| DA | THE REVIEW OF SCIENTIFIC INSTRUMENTS, Vol. 38, Nr. 3, März 1967, USA, <br> N. MIYAMOTO et al., "Contactless measurement of resistivity of slices of semiconductor materials" Seiten 360-367 <br> * Seite 367, Absatz "Measurement of lifetime" * | 1 |

./.

**KLASSIFIKATION DER ANMELDUNG (Int.Cl.²)**

G 01 N 31/26
27/02
27/86
H 01 L 23/00

**RECHERCHIERTE SACHGEBIETE (Int Cl.²)**

G 01 R 31/26
31/28
G 01 N 27/02
27/24
27/90

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 19-03-1979 | DUCHATELLIER |